# EUROPEAN PATENT APPLICATION

(11) **EP 2 317 563 A2**
(43) Date of publication of application: **04.05.2011**
(21) Application number: 09805196.4
(22) Date of filing: 06.08.2009
(51) Int. Cl.: H01L 31/042

(54) **PRODUCTION METHOD FOR DYE-SENSITIZED SOLAR CELL**

(30) Priority: 08.08.2008 KR 20080077734
(71) Applicant: Dongjin Semichem Co., Ltd., Seo-gu Incheon 404-205 (KR)
(72) Inventor: PARK, Tae-jin, Incheon 405-759 (KR); MOON, Hyoung-don, Osan City Gyeonggi-Do 447-270 (KR); BAE, Ho-gi, Pyeongtaek-City Gyeonggi-Do 451-781 (KR)
(74) Representative: Bockhorni & Kollegen
(86) International application number: PCT/KR2009/004394
(87) International publication number: WO 2010/016735

(57) **Abstract**

Disclosed is a method for preparing a dye-sensitized solar cell comprising forming a photoelectrode layer and adsorbing dye into the photoelectrode layer, wherein the method further comprises irradiating UV to the photoelectrode layer before the adsorption of the dye.

According to the method, remaining organic substance and contaminant in the photoelectrode layer are decomposed and removed by the UV irradiation, and the material forming the photoelectrode layer itself functions as a photocatalyst, and thus, if electrons are excited by the UV irradiation, surrounding H₂O or O₂ takes the electrons to decompose surrounding organic substance, to wash the surface of the photoelectrode layer before the adsorption of dye thereby improving adsorption efficiency, and the photoelectrode layer is activated by the UV irradiation to facilitate adsorption thereby also increasing dye adsorption efficiency, thus largely improving dye adsorption efficiency in two ways, to improve photoelectric conversion efficiency of a solar cell.

## Description

### BACKGROUND OF THE INVENTION

### (a) Field of the Invention

The present invention relates to a method for manufacturing a dye-sensitized solar cell, more particularly to a method for manufacturing a dye-sensitized solar cell that wherein remaining organic substance and contaminant in the photoelectrode layer are decomposed and removed by the UV irradiation, and the material forming the photoelectrode layer itself functions as a photocatalyst, and thus, if electrons are excited by the UV irradiation, surrounding H₂O or O₂ takes the electrons to decompose surrounding organic substance, to wash the surface of the photoelectrode layer before the adsorption of dye thereby improving adsorption efficiency, and the photoelectrode layer is activated by the UV irradiation to facilitate adsorption thereby also increasing dye adsorption efficiency, thus largely improving dye adsorption efficiency in two ways, to improve photoelectric conversion efficiency of a solar cell.

### (b) Description of the Related Art

Since a dye-sensitized nanoparticle titanium oxide solar cell was developed by Michael Gratzel et al. of Swiss Federal Institute of Technology Lausanne(EPFL) at the year of 1991, many studies on this field are under progress. Because the dye-sensitized solar cell has high efficiency and remarkably low manufacture cost compared to the existing silicon solar cell, it may replace the existing amorphous silicon solar cell. The dye-sensitized solar cell is a photoelectrochemical solar cell mainly comprising dye molecules capable of absorbing visible rays to generate electron-hole pair, and transition metal oxide for transmitting the generated electrons.

In general, a unit cell of a dye-sensitized solar cell consists of upper and lower transparent substrates, a conductive transparent electrode consisting of transparent conductive oxide (TCO) respectively formed on the surface of the transparent substrates, a dye-adsorbed transition metal oxide porous layer formed on one conductive transparent electrode corresponding to a first electrode, a catalyst thin film electrode formed on the other conductive transparent electrode corresponding to a second electrode, and electrolyte filled between the transition metal oxide, for example TiO₂, porous electrode and the catalyst thin film electrode. Thus, the dye-sensitized solar cell basically consists of a photoelectrode substrate on which photoelectrode material (TiO₂) to which dye receiving light to generate electrons is attached is coated, a catalyst electrode substrate supplying electrons, and electrolyte supplying electrons to dye therebetween, and photoelectric conversion efficiency of the dye-sensitized solar cell is determined by the degrees of dye adsorption onto the photoelectrode and conversion of light into electricity.

In general, in the transition metal oxide porous layer (a porous photoelectrode layer) (TiO₂) forming the photoelectrode part of the dye-sensitized solar cell, TiO₂ paste is formed as a film and heat-treated to remove organic substance forming the paste, and TiO₂ nanoparticles are necked to facilitate movement of electrons injected from the dye.

However, during the process, organic substance derived from the paste may remain in the porous photoelectrode layer (TiO₂) or contamination may occur, and then, dye may not be efficiently chemically adsorbed onto the TiO₂ surface constituting the porous photoelectrode layer.

Accordingly, there is an urgent need for development of a manufacturing method capable of properly adsorbing more dyes onto the photoelectrode layer comprising a transition metal oxide porous layer.

### SUMMARY OF THE INVENTION

Accordingly, it is an object of the present invention to provide a method for preparing a dye-sensitized solar cell that may decompose and remove remaining organic substance and contaminant in the photoelectrode layer, and decompose surrounding organic substance by the material forming the photoelectrode layer, to wash the surface of the photoelectrode layer before the adsorption of dye, and facilitate adsorption by activation of the photoelectrode layer, thereby improving dye adsorption efficiency, and thus improving photoelectric conversion efficiency of a solar cell

In order to achieve the object, the present invention provides a method for preparing a dye-sensitized solar cell comprising forming a photoelectrode layer and adsorbing dye into the photoelectrode layer,
wherein the method further comprises irradiating UV to the photoelectrode layer before the adsorption of the dye.

According to the method for manufacturing a dye-sensitized solar cell of the present invention, remaining organic substance and contaminant in the photoelectrode layer are decomposed and removed by the UV irradiation, and the material forming the photoelectrode layer itself functions as a photocatalyst, and thus, if electrons are excited by the UV irradiation, surrounding H₂O or O₂ takes the electrons to decompose surrounding organic substance, to wash the surface of the photoelectrode layer before the adsorption of dye thereby improving adsorption efficiency, and the photoelectrode layer is activated by the UV irradiation to facilitate adsorption thereby also increasing dye adsorption efficiency, thus largely improving dye adsorption efficiency in two ways, to improve photoelectric conversion efficiency of a solar cell.

### BRIEF DESCRIPTION OF THE DRAWINGS

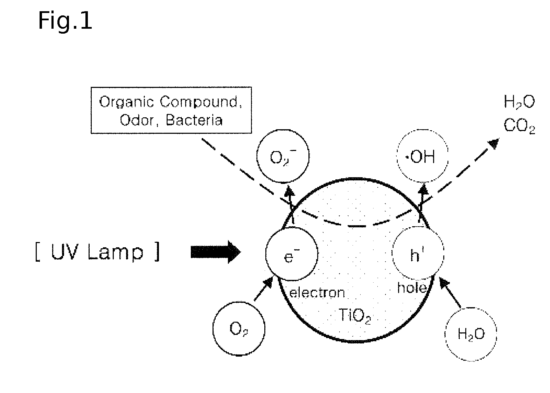

Fig. 1 schematically shows a washing mechanism of the method for manufacturing a dye-sensitized solar cell of the present invention, in case photocatalyst property is generated in the photoelectrode layer.

### DETAILED DESCRIPTION OF THE EMBODIMENTS

Hereinafter, the present invention is explained in detail.

The method for manufacturing a dye-sensitized solar cell of the present invention, which comprises forming a photoelectrode layer and adsorbing dye into the photoelectrode layer, further comprises irradiating UV to the photoelectrode layer before the adsorption of the dye.

This is explained in more detail referring to the drawing.

Specifically, a dye-sensitized solar cell basically consists of a photoelectrode substrate on which a photoelectrode material (for example, TiO₂) to which dye receiving light to generate electrons is attached is coated, a catalyst electrode substrate providing electrons, and electrolyte providing electrons to oxidized dye. Thus, in general, a dye-sensitized solar cell consists of the two substrates opposing each other.

The photoelectrode part formed of photoelectrode material consists of a photoelectrode layer to which dye receiving light to generate electrons is attached, and transparent conductive material (TCO) for electrical connection thereunder, wherein the photoelectrode layer mainly consists of transition metal oxide n-type semiconductor material to which dye is adsorbed, the transition metal oxide (for example, TiO₂) forming the photoelectrode layer has an average particle size of 10 ~ 50 nm, and the photoelectrode is mainly formed as a thin layer of a thickness of about 15 µm and forms a porous thin layer having very large specific surface area. Thus, dye particles are chemically adsorbed onto the large surface area to maximize photoelectric conversion efficiency.

Therefore, to maximize photoelectric conversion efficiency, dye should be stably adsorbed in a large quantity. Thus, the present invention utilizes the photocatalyst characteristic of TiO₂ as shown in Fig. 1 so as to activate a photoelectrode layer, preferably a TiO₂ porous layer, before adsorbing dye on the TiO₂ layer. For this, UV is irradiated before the adsorption of dye to activate the photoelectrode layer, preferably a TiO₂ layer, so as to function as the photocatalyst through the process as shown in Fig. 1. Thus, if electrons are excited by the UV irradiation, surrounding H₂O or O₂ takes to decompose surrounding organic substance, thereby washing the surface of the photoelectrode layer before the adsorption of dye, and simultaneously activating the surface of the photoelectrode layer, preferably the surface of TiO₂ particles, thus maximizing the effect of dye adsorption, to improve photoelectric conversion effect of a dye-sensitized solar cell. And, since it is commonly known that UV itself has the effect of decomposing organic substance, the above described washing effect may further increase.

Preferably, the UV irradiation is conducted immediately before the adsorption of dye so as to maintain activation and maximize washing effect.

Specifically, as described in the background of the invention, according to a common manufacturing method of a dye-sensitized solar cell, TiO₂ paste is formed as a film and heat-treated to remove organic substance forming the paste, and TiO₂ nanoparticles are necked to facilitate movement of electrons injected from dye in a porous photoelectrode layer (TiO₂) forming a photoelectrode part. However, since organic substance may remain in the porous photoelectrode layer (TiO₂) or contaminant may be generated during the above process, according to the present invention, UV is irradiated to the porous photoelectrode layer (TiO₂) using photocatalyst action of TiO₂ and photoenergy supply and organic substance decomposition of UV before the adsorption of dye, thereby removing remaining organic substance or contaminant and simultaneously activating the porous photoelectrode layer, to increase dye adsorption efficiency and improve adsorption strength, thus improving photoelectric conversion efficiency of a solar cell.

The method for manufacturing a dye-sensitized solar cell of the present invention may be conducted identically or similarly to a common manufacturing method of a dye-sensitized solar cell, except the above described technical features, and thus, explanations thereof are omitted.

The present invention also provides a dye-sensitized solar cell prepared by the above method, which comprises a photoelectrode consisting of the dye-adsorbed photoelectrode layer prepared by the above method; a catalyst electrode corresponding to the photoelectrode; electrolyte electrically connecting the photoelectrode and the catalyst electrode; and a sealing part that seals the photoelectrode, the catalyst electrode and electrolyte with an upper plate, a lower plate and sealing material.

The dye-sensitized solar cell may be formed as an identical or similar structure to a common dye-sensitized solar cell, except the above described technical features, and thus, explanations thereof are omitted.

While this disclosure has been described in connection with what is presently considered to be practical exemplary embodiments, it is to be understood that the invention is not limited to the disclosed embodiments, but, on the contrary, is intended to cover various modifications and equivalent arrangements included within the spirit and scope of the appended claims.

According to the method, remaining organic substance and contaminant in the photoelectrode layer are decomposed and removed by the UV irradiation, and the material forming the photoelectrode layer itself functions as a photocatalyst, and thus, if it is activated by excitation of electrons by the UV irradiation, surrounding H₂O or O₂ takes the electrons to decompose surrounding organic substance, to wash the surface of the photoelectrode layer before the adsorption of dye thereby improving adsorption efficiency, and the photoelectrode layer is activated by the UV irradiation to facilitate adsorption thereby also increasing dye adsorption efficiency, thus largely improving dye adsorption efficiency in two ways, to improve photoelectric conversion efficiency of a solar cell.

## Claims

1. A method for preparing a dye-sensitized solar cell comprising forming a photoelectrode layer and adsorbing dye into the photoelectrode layer,
wherein the method further comprises irradiating UV to the photoelectrode layer before the adsorption of the dye.

2. The method according to claim 1, wherein the UV irradiation is performed immediately before the adsorption of dye.

3. The method according to claim 1, wherein the photoelectrode layer is a porous TiO₂ film.

4. A dye-sensitized solar cell comprising:
a photoelectrode comprising the dye-adsorbed photoelectrode layer prepared by the method of claim 1;
a catalyst electrode corresponding to the photoelectrode;
electrolyte electrically connecting the photoelectrode and the catalyst electrode; and,
a sealing part that seals the photoelectrode, the catalyst electrode and electrolyte with an upper plate, a lower plate and sealing material.
